# EUROPEAN PATENT SPECIFICATION

(11) **EP 2 294 496 B1**
(45) Date of publication and mention of the grant of the patent: **28.06.2017**
(21) Application number: 09751558.9
(22) Date of filing: 21.05.2009
(51) Int. Cl.: G06F 1/20, G06F 1/16, H05K 7/20, H05K 7/14, F28D 15/02, F28D 15/00, F28F 3/12, H01L 23/42, H01L 23/46

(54) **GRAPHICS CARD THERMAL INTERPOSER**
THERMISCHES ZWISCHENGLIED FÜR GRAFIKKARTEN
ÉLÉMENT D'INTERPOSITION THERMIQUE POUR CARTE GRAPHIQUE

(30) Priority: 21.05.2008 US 54992
(43) Date of publication of application: 16.03.2011
(73) Proprietor: Asetek A/S, 9700 Bronderslev (DK)
(72) Inventor: ALYASER, Monem, H., San Jose CA 95125 (US); RICE, Jeremy, A., San Jose CA 95126 (US)
(74) Representative: Chas. Hude A/S
(86) International application number: PCT/US2009/044813
(87) International publication number: WO 2009/143330

(56) References cited:
- EP-A2- 1 391 673
- EP-A2- 1 482 396
- US-A1- 2004 190 255
- US-A1- 2004 190 255
- US-A1- 2006 109 631
- US-A1- 2007 188 991
- US-A1- 2007 211 432

## Description

### BACKGROUND OF THE INVENTION

The present invention is related generally to a system for cooling component circuit boards, electronic components, and heat sources associated with electronic components, and is directed specifically to a cooling system component adapted for use in conjunction with a liquid cooling system for cooling integrated circuit components such as those found on graphics cards in a personal computer system.

Personal computer systems which are designed for desktop or under-desk use, and which are typically characterized by a main-board or motherboard housed in a chassis or case. Auxiliary components additionally contained within the chassis or case may include network adapter circuit boards, modems, specialized adapters, and graphics display adapters. These auxiliary components may receive power through the connection to the motherboard, or through additional connections directly to a system power supply contained within the chassis or case. Additional components which generate heat, such as hard drives, disk drives, media readers, etc. may further be contained within the chassis or case, and coupled to the system power supply and motherboard as needed.

During operation, the motherboard and various auxiliary components consume power and generate heat. To ensure proper functionality of the computer system, it is necessary to regulate the operating temperatures inside the environment of the chassis or case. Individual integrated circuits, especially memory modules and processors, may generate significant amounts of heat during operation, resulting in localized hot spots within the chassis environment. The term "processors", as used herein, and as understood by one of ordinary skill in the art, describes a wide range of components, which may include dedicated graphics processing units, microprocessors, microcontrollers, digital signal processors, and general system processors such as those manufactured and sold by Intel and AMD. In an air-cooled system, the generated heat is absorbed by the ambient air within the chassis, which is then circulated or exchanged by various cooling fans. Failure to maintain adequate temperature control throughout the chassis environment, and at individual integrated circuits, can significantly degrade the system performance and may eventually lead to component failure.

Traditionally, a cooling fan is often associated with the system power supply, to circulate air throughout the chassis environment, and to exchange the high temperature internal air with cooler external air. However, as personal computer systems include increasing numbers of individual components and integrated circuits, and applications become more demanding on additional processing components such as graphics display adapters, a system power supply cooling fan may be inadequate to maintain the necessary operating temperatures within the chassis environment.

Specialized liquid cooling systems are available for some components in a personal computer system. Specialized liquid cooling systems typically required a coolant circulation pathway, which routes a thermal transfer liquid between a heat exchanger such as a radiator and a heat source, such as a CPU, GPU, microprocessor or transformer. Specialized liquid cooling systems are well adapted for maintaining adequate operating temperatures for individual components. However, these specialized liquid cooling systems are not easily adapted for use with a wide variety of components or adapter boards in a personal computer system. Furthermore, once such liquid cooling systems are installed, it is difficult to replace, insert, or remove components requiring cooling from the system, as the liquid cooling system must either be drained or breached to facilitate the replacement, insertion, or removal.

Some specialized liquid cooling systems adapted for use with plug-in adapter cards such as graphic cards utilize a cold plate component through which a cooling liquid circulates for cooling the main processor on the adapter card, and thermal radiators for air cooling the other circuit components on the adapter card. These systems often add significant space requirements to the adapter card, necessitating the use of two adapter "slots" or bays. Additionally, by continuing to utilize thermal radiators for air cooling, these systems contribute heat to the internal environment within the computer chassis, increasing the strain on other cooling components.

Personal computers are not the only electronic devices which generate heat during use. Many electronic devices contained within a chassis or case generate heat during use which must be dissipated. For example, multiple circuitboards, DC/DC converters, hard drives, optical components, rack-mounted servers, blade servers, networking switches and routers, network storage devices, military and medical electronic equipment, as well as instrumentation and testing electronics all generate heat during use which must be dissipated to avoid damage to the system.

Accordingly, it would be advantageous to provide a component for use with a liquid cooling system which may be easily adapted to provide a liquid cooling mechanism for a wide range of heat generating integrated circuit components, such as a personal computer adapter card, to cool both the adapter card processors as well as associated integrated circuits. It would be further advantageous to provide a component for a liquid cooling system which may be easily detached from an associated heat source without draining of any liquid coolant or breaching of the coolant flow pathways, enabling replacement, addition, or removal of heat source components such as upgraded processors, and which does not significantly increase the space requirements for the adapter card.

EP 1 391 673 discloses a flat heat transferring device including a lower plate, an upper plate, a wick plate, and a liquid-phase coolant. The lower plate contacts a heat source at its bottom. The upper plate is hermetically coupled with the lower plate along its edge to form a void therebetween and contacts a heatsink at its top.

EP 1 482 396 discloses a cooling system for a portable computer can include a frame having a heat-source connecting unit in its one side and having a fan housing unit in its other side. A plate-shaped cooling unit coupled to one side of the frame can deliver heat from the heat-source connecting unit to the dissipating unit. The cooling unit can include a micro cooling unit that performs heat exchange using a cooling cycle through phase change or a plate-heat pipe filled with liquid.

US 2004/0190255 discloses a water cooling type cooling jacket for an electronic device including a pouch body formed of a soft, loose elastic material that is deformable to closely contact heat-generating elements having various shapes clue to a contact pressure and accommodating and a coolant, and a coolant inlet tube and a coolant outlet tube formed at one side of the pouch body to allow the coolant to circulate inside the pouch body and connected to coolant circulation lines for circulating the coolant.

### BRIEF SUMMARY OF THE INVENTION

Briefly stated, the present disclosure provides a thermal interposer component for thermally coupling a liquid cooling system to a personal computer adapter card having heat sources. The thermal interposer component comprises a planar body of a thermally conductive material, configured for attachment to the personal computer adapter card, in thermal contact on one face with multiple heat sources on the adapter card, such as a processor component. The thermal interposer component further comprises a thermal discharge region forming the receiving space or socket for receiving a standardized modular cold plate assembly removably coupled to said planar body, said modular cold plate assembly operatively coupled to a liquid cooling system to transfer thermal energy from the planar body to a coolant circulating within the liquid cooling system.

The disclosure further presents a plurality of heat pipes that are embedded within the planar body to facilitate a transfer of thermal energy absorbed by the planar body from the heat sources. A cold plate component coupled to a liquid cooling system is operatively coupled to the planar body on a face opposite from the multiple heat sources to drawn heat from the planar body, the heat pipes, and from the at least one processor via a circulating liquid coolant.

In one embodiment, the planar body of the thermal interposer component is composed of an aluminum die cast plate. The dimensions of the thermal interposer component are selected based upon the computer adapter card to which the thermal interposer component is coupled, and are further selected to enable the combined assembly of the computer adapter card, thermal interposer component, and an operatively coupled cold plate component to fit within the spatial requirements of a single-slot personal computer adapter card.

The foregoing features, and advantages set forth in the present disclosure as well as presently preferred embodiments will become more apparent from the reading of the following description in connection with the accompanying drawings.

### BRIEF DESCRIPTION OF THE SEVERAL VIEWS OF THE DRAWINGS

In the accompanying drawings which form part of the specification:
Figure 1 is an exploded view of a cold plate component of the present disclosure having a base portion, a central coolant circulation portion, and a top portion;
Figure 2a-2c illustrate the top portion, bottom portion, and medially disposed heat pipes of an adapter card thermal interposer of the present disclosure in an exploded view;
Figure 3 is an exploded view of an adapter card assembly incorporating the thermal interposer of Figs. 2a-2c and the cold plate component of Fig. 1; and
Figure 4 is an exploded view of an adapter card assembly incorporating an alternate embodiment thermal interposer and cold plate component of the present disclosure.

Corresponding reference numerals indicate corresponding parts throughout the several figures of the drawings. It is to be understood that the drawings are for illustrating the concepts set forth in the present disclosure and are not to scale.

Before any embodiments of the invention are explained in detail, it is to be understood that the invention is not limited in its application to the details of construction and the arrangement of components set forth in the following description or illustrated in the drawings.

### DETAILED DESCRIPTION

The following detailed description illustrates the invention by way of example and not by way of limitation. The description enables one skilled in the art to make and use the present disclosure, and describes several embodiments, adaptations, variations, alternatives, and uses of the present disclosure, including what is presently believed to be the best mode of carrying out the present disclosure.

Personal computers, network servers, and many other variations of computing devices employ electronic sub-components such as circuit boards, adapter cards, daughter cards, DC/DC converters, hard drives, and optical drives mounted in an enclosed case or chassis. These various electronic sub-components, including a common power supply, generate heat during operation which must be dissipated from the chassis or case to avoid heat-induced damage or overheating of the various components. Common methods for extracting heat from the internal volume of a computer case or chassis include providing cooling fans for circulating airflow, and the use of liquid cooling systems to circulate a liquid coolant between the various sources of heat and a liquid-to-air radiator for discharge outside of the chassis. Typically, to utilize a circulating liquid coolant within a computing device case or chassis, individual components much be customized or configured with coolant flow pathways for connecting to the liquid coolant circulation system. Installation, removal, or replacement of components is difficult due to the need to breach the liquid coolant circulation system when altering the component configurations, resulting in the loss of liquid coolant and/or the introduction of air into the liquid coolant circulation system, which can reduce the thermal efficiency of the system.

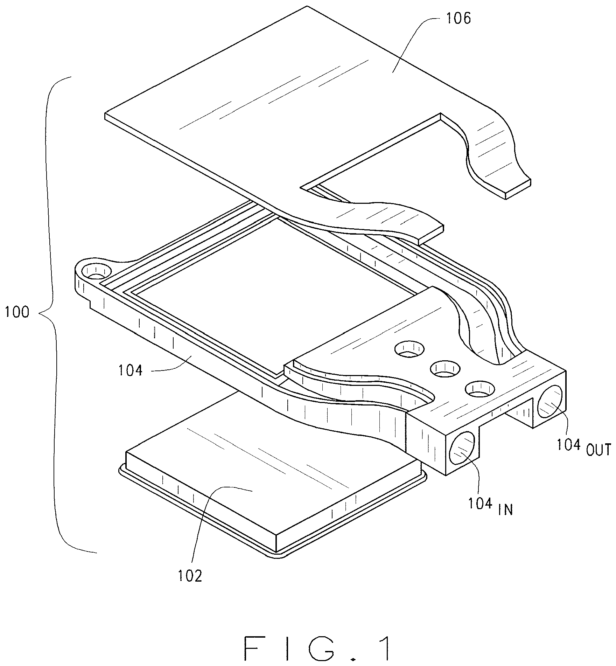

Turning to Figure 1, a modular cold-plate assembly of the present disclosure for use with a thermal interposer component is shown generally at 100. The modular cold-plate assembly provides a standardized heat transfer component for a liquid cooling system such as may be used within a chassis or case of a computer system. As seen at Fig. 1, the modular cold-plate assembly 100 consists of a cold plate body 102, configured for placement in thermal proximity to a heat source (not shown), a fluid circulation body 104, configured to circulate a flow of liquid coolant around the cold plate body 102, and a cover plate 106 configured to enclose the cold plate body 102 within the fluid circulation body 104.The external dimensions of the modular cold-plate assembly 100 are preferably standardized to facilitate reuse and interchange of the modular cold-plate assembly 100 with different thermal interposer components as required from time to time.

The cold plate body 102 is a sealed component made from materials which have a high conductivity to facilitate a transfer of heat, such as metals like copper or aluminum. Exemplary cold plate components are shown and described in co-pending International Application No. PCT/US08/56167 and in co-pending U.S. Patent Application Serial No. 12/053,202, each of which is herein incorporated by reference. The cold plate body 102 is adapted for placement in contact with the surface of the heat source (not shown), and preferably consists of a high conductivity material which is adapted for contact with the heat source. Heat is transferred from the heat source through the region of high conductivity material 102, such as copper, to the liquid coolant circulating within the volume of the fluid circulation body 104 between the cold plate body 102 and the cover plate 106. Essentially, liquid coolant enters the volume of the fluid circulation body 104 through a coolant inlet port 104_{IN}, circulates around the exposed peripheral surfaces of the cold plate body 102, and exits the fluid circulation body 104 via a coolant outlet port 104_{OUT}. The inlet and outlet ports 104_{IN} and 104_{OUT} are connected, via suitable couplings and tubing, to a liquid cooling circulation system associated with the chassis or case. Those of ordinary skill in the art will recognize that the general function of a liquid cooling system is well know for transferring thermal energy from heat sources, and as such, the components thereof will not be described in detail.

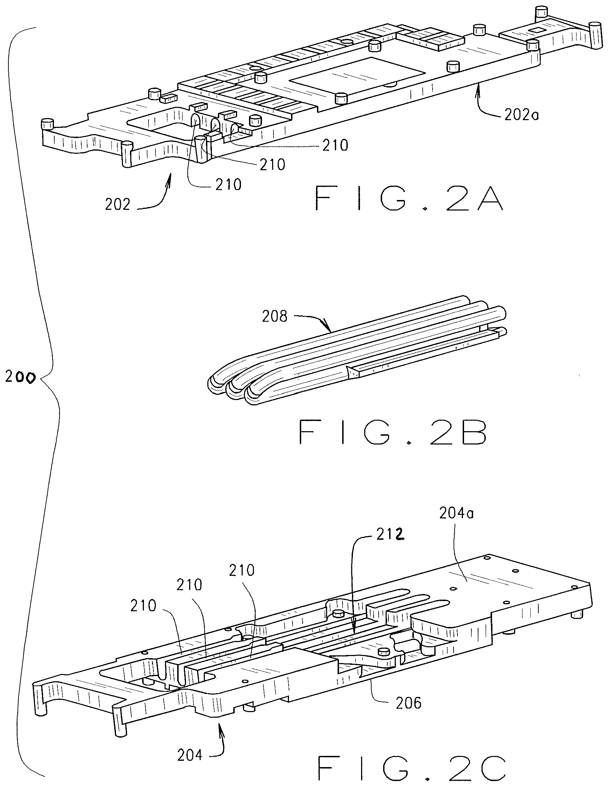

In general, the external dimensions of the modular cold plate assembly 100 are standardized to fit within a corresponding receiving space or socket within a thermal interposer assembly 200 of the present disclosure. Turning to Figures 2A-2C, an embodiment of a thermal interposer assembly 200 adapted for use with a personal computer adapter card, such as a graphics display adapter card, having multiple integrated circuits which generate heat during operation is shown generally. These integrated circuits may include, but are not limited to, voltage regulators, switches, memory components, ASICs, LEDs, DSPs, and processing components, such as general purpose processors or dedicated graphics processing units. The thermal interposer assembly 200 consists of an upper planar segment 202 and a lower planar segment 204 which seat together along mating faces 202a and 204a to form a generally planar body. The upper and lower planar segments 202 and 204 are generally unitary components, formed from a thermally conductive material, such as die-cast aluminum or graphite, and are configured for attachment to a personal computer adapter card. The lower planar segment 204 of the planar body is disposed with one side 206 generally in thermal contact with multiple heat sources on the adapter card, including at least one processor. To ensure adequate thermal contact, thermal grease or thermal gap pads may be utilized between the heat sources and the face 206 of the lower planar segment 204.

Preferably, one or more heat pipes 208 are seated within recesses 210 in the mating faces 202a, 204a, and are configured to facilitate a transfer and distribution of the thermal energy absorbed by the planar body away from the heat sources and towards a thermal discharge region 212 of the planar body which forms the receiving space or socket for the modular cold plate assembly 100. Those of ordinary skill in the art will recognize that the specific configuration of the heat pipes 208 within the planar body may be varied, depending upon the particular thermal transfer needs of each application. For example, as shown in Figure 2b, the heat pipes may be disposed in a generally parallel configuration, terminating in, or passing through the thermal discharge region 212 of the planar body.

The thermal discharge region 212, which is preferably disposed in proximity to the heat source having the greatest thermal output, such as a CPU or GPU, is a recessed region in the mating face 202a, enclosed by the mating face 204a to define a receiving slot or socket which is configured to receive the modular cold plate assembly 100. As described above, the cold plate assembly 100 is coupled to a liquid coolant circulation system via inlet and outlet portions 104_{IN} and 104_{OUT}. As the liquid coolant circulates through the cold plate assembly 100, thermal energy is drawn from each planar body, the one or more heat pipes 208, and from the various heat sources, including the processor, and is transported via the liquid coolant flow for discharge remotely from the thermal interposer assembly 200 and associated heat sources.

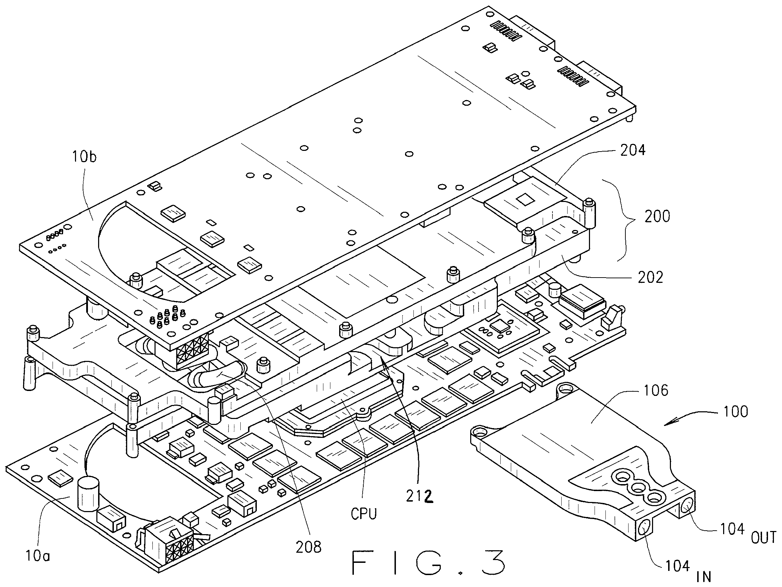

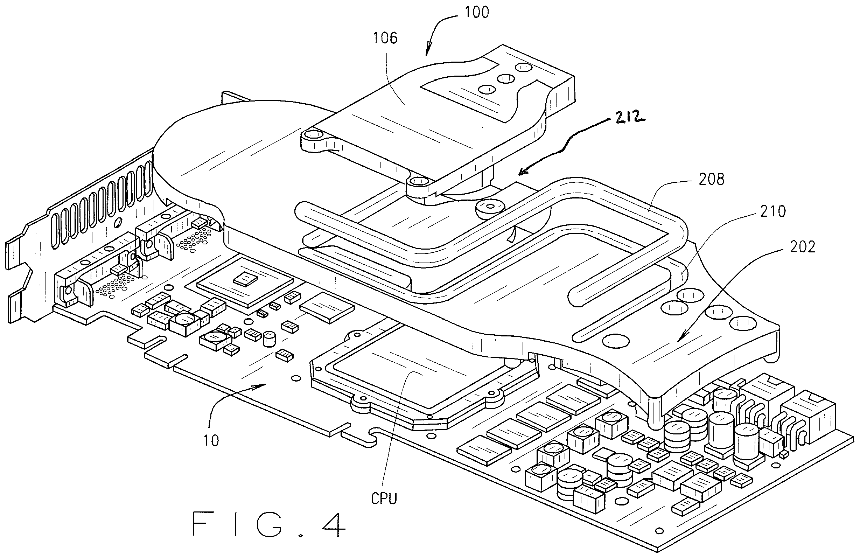

Generally, as shown in Figure 3, the dimensions of the thermal interposer component planar body are selected based upon the configuration of the computer adapter card 10a, 10b to which the thermal interposer component 200 is to be coupled, and are further selected to enable the combined assembly of the computer adapter card 10a, 10b, the thermal interposer component 200, and the operatively coupled cold plate assembly 100 to fit within the spatial requirements of either a single-slot or double-slot personal computer adapter card. Those of ordinary skill in the art will recognize that the thermal interposer component 200 may have any of a variety of different configurations based upon the particular physical space limitations associated with the electronic components being cooled, and upon the arrangement of heat sources in thermal proximity to the surfaces of the thermal interposer. For example, while the embodiment shown in Figure 3 illustrates a thermal interposer 200 of the present disclosure having a pair of planar bodies 202 and 204 disposed in a sandwiched configuration between a pair of circuit boards 10a and 10b, the embodiment shown in Figure 4 illustrates an alternate configuration of the thermal interposer having only a single planar body 202 disposed adjacent a single circuit board 10, sized to fit within a double-slot PC card configuration.

The embodiment shown in Figure 4 illustrates an optional arrangement wherein only a single lower planar body 202 is utilized adjacent a single circuit board 10 and associated heat sources, without an upper planar body 204. The heat pipe 208 is routed through a serpentine path to facilitate transfer of thermal energy from the lower planar body 202 to the thermal transfer region 212, defined by a recessed seat or socket for receiving a modular cold plate assembly 100, and the associated cold plate assembly 100.

The use of the thermal interposer assembly 200 of the present disclosure provides several advantages for the cooling and temperature management of personal computer adapter cards, circuit boards, or other electronic components. By removably coupling the modular cold plate assembly 100 to a planar body 202 which, in turn, is in thermal contact with the various heat sources on an adapter card 10 or circuit board, the design of the liquid cooling system (not shown) may be standardized and simplified through the use of the common modular cold plate assembly 100 configuration, requiring only one or more of the thermal interposer planar bodies 202 and 204 to be modified to fit different adapter cards 10, circuit boards, or other electronic components. This in turn, reduces development and production cycles, as well as production costs. Exchange, replacement, or addition of adapter cards 10, circuit boards, or other electronic components in need of cooling to a system does not require breech of the liquid coolant circulation pathways, as the modular cold plate assembly 100 provides a standardized component which may be disconnected from a thermal interposer assembly 200 and re-installed in a replacement component without removal from the liquid coolant system or breach of the liquid coolant pathways, thereby reducing the risk of coolant loss, leaks, or the introduction of air into the system. For example, a personal computer may be provided with a liquid coolant circulation system in which a number of modular cold plate assemblies 100 are coupled to the liquid coolant circulation pathways, and which may be seated or socketed, as needed, in the thermal transfer regions 212 or slots 210 on the thermal interposer assemblies 200 associated with adapter cards 10 or other internal peripheral components installed from time to time in the chassis or case of the personal computer.

With a planar body 202 or 204 of thermal interposer 200 in thermal contact with a plurality of heat sources, efficient cooling of multiple circuits on the adapter card 10 or circuit board is achieved with a common cooling system, eliminating the need for separate or individual cooling systems associated with each adapter card or circuit board. Heat drawn from the heat sources is retained within the planar bodies 202, 204 of the thermal interposer assembly 200 for transfer to the liquid coolant circulating through the modular cold plate assembly 100, reducing heat transfers to the ambient air surrounding the adapter card and contained within the computer chassis. Similarly, by transferring heat to the liquid coolant, the need for air circulating fans in proximity to the adapter card or circuit board is eliminated, and the overall card assembly, including the thermal interposer 200 and cold plate component 100 may be configured to fit within a selected spatial volume corresponding to a single-slot adapter card or a double-slot adapter card.

As various changes could be made in the above constructions without departing from the scope of the disclosure, it is intended that all matter contained in the above description or shown in the accompanying drawings shall be interpreted as illustrative and not in a limiting sense. For example, while the present disclosure illustrates the use of die-cast aluminum to form the planar body of the thermal interposer, those of ordinary skill in the art will recognize that any suitable thermally conductive material may be utilized, formed by any suitable forming techniques. Similarly, the specific planar configuration of the planar body shown in the drawings will be understood to be exemplary, and may be modified as required to suit any of a variety of personal computer adapter card configurations without departing from the scope of the invention.

## Claims

1. A thermal interposer component (200) for thermally coupling a liquid cooling system to a computer adapter card (10; 10a, 10b) having heat sources, comprising:
a planar body (202; 202, 204) of a thermally conductive material, configured for attachment to the computer adapter card, in thermal contact on one face with multiple heat sources on the computer adapter card;
**characterised in that** the thermal interposer component further comprises a thermal discharge region (212) forming a receiving space or socket for receiving a standardized modular cold plate assembly (100) removably coupled to said planar body, said modular cold plate assembly operatively coupled to a liquid cooling system (104) to transfer thermal energy from the planar body to a coolant circulating within the liquid cooling system.

2. The thermal interposer component of claim 1 wherein the planar body of said system further comprises at least one heat pipe (208) recessed within the planar body to facilitate a transfer an distribution of thermal energy absorbed by the planar body from said heat sources.

3. The thermal interposer component of Claim 2 wherein said at least one heat pipe is disposed to transport thermal energy through said planar body towards said cold plate component.

4. The thermal interposer component of Claim 1-3 wherein said planar body is composed of aluminum.

5. The thermal interposer component of Claim 1-3 wherein said planar body is composed of graphite.

6. The thermal interposer componenet of claim 1-5, wherein the modular cold plate assembly is removably coupled to a receiving socket in the planar body, said receiving socket defining said thermal discharge region on a face of said planar body opposite from said at least one heat source.

7. The thermal interposer component of Claim 6 wherein said at least one heat source is a processor disposed on said computer adapter card, and wherein said thermal discharge region and said modular cold plate assembly are disposed diametrically opposite on said planar body from said at least one processor.

8. The thermal interposer component of Claim 6-7 wherein said thermal discharge region and said associated modular cold plate assembly are disposed on said planar body diametrically opposite from a heat source on said electronic component having the greatest thermal output.

9. The thermal interposer component of Claim 1-8 wherein said electronic component is a personal computer adapter card, and wherein said planar body and said modular cold plate assembly, when operatively assembled and coupled to said personal computer adapter card, fit within a selected spatial volume allotted for a personal computer adapter card within a personal computer chassis.

10. The thermal interposer component of Claim 9 wherein said selected spatial volume is defined by a standard single-slot personal computer adapter card configuration.

11. The thermal interposer component of Claim 9 wherein said selected spatial volume is defined by a standard double-slot personal computer adapter card configuration.

12. The thermal interposer component of Claim 1-11 including a plurality of heat pipes recessed within the planar body to facilitate said distribution and transfer of thermal energy absorbed by the planar body to said modular cold plate component.

13. The thermal interposer component of Claim 12 wherein said plurality of heat pipes are symmetrically disposed within the planar body.

14. The thermal interposer component of Claim 1-13 wherein a layer of thermal grease is disposed to facilitate a transfer of thermal energy from said planar body to said modular cold plate component.

15. The thermal interposer component of Claim 1-14 further include one or more thermal gap pads disposed between said at least one heat source and said planar body to facilitate a transfer of thermal energy to said planar body.

16. The thermal interposer component of Claim 1-15 wherein said planar body consists of a lower planar body adapted for placement with a first planar surface in thermal adjacency to said at least one heat source of said electronic component; and an upper planar body having a planar mating surface adapted to seat against a corresponding planar mating surface of said lower planar body, and further adapted for placement with a second planar surface in thermal adjacency to a second heat source of said electronic component; and
wherein said upper planar body and said lower planar body cooperatively define at least one passage for receiving said heat pipe, and said thermal discharge region for receiving said modular cold plate assembly there between.

17. A planar body for a thermal interposer component according to claim 1-16, said planar body being of a thermally conductive material, configured for attachment to the electronic component, in thermal contact on one face with at least one heat source on the electronic component.

18. A modular cold plate assembly for a thermal interposer component according to claim 1-16.

## Patentansprüche

1. Eine thermische Interposer-Komponente (200) zum thermischen Koppeln eines Flüssigkühlsystems an eine Computer-Adapterkarte (10; 10a, 10b) mit Wärmequellen, umfassend:
einen planaren Korpus (202; 202, 204) eines thermisch leitenden Materials, gestaltet zur Befestigung an einer Computer-Adapterkarte, auf einer Seite in thermischem Kontakt mit mehreren Wärmequellen der Computer-Adapterkarte;
dadurch charakterisiert, dass die thermische Interposer-Komponente außerdem einen thermischen Abgabebereich (212) umfasst, der einen Aufnahmeplatz oder -sockel bildet, zum Aufnehmen einer standardisierten modularen Kühlplatten-Anordnung (100), die abnehmbar an jenen planaren Korpus gekoppelt ist, wobei jene modulare Kühlplatten-Anordnung operativ an ein Flüssigkühlsystem (104) gekoppelt ist, um thermische Energie vom planaren Korpus an ein Kühlmittel, das innerhalb des Flüssigkühlsystems zirkuliert, zu transferieren.

2. Die thermische Interposer-Komponente von Anspruch 1, wobei der planare Korpus jenes Systems außerdem mindestens ein Wärmerohr (208) umfasst, das in dem planaren Korpus versenkt ist, um einen Transfer und eine Verteilung von thermischer Energie, die durch den planaren Korpus von jenen Wärmequellen absorbiert wurde, zu ermöglichen.

3. Die thermische Interposer-Komponente von Anspruch 2, wobei jenes mindestens eine Wärmerohr angeordnet ist, um thermische Energie durch jenen planaren Korpus zu jener Kühlplatten-Komponente zu transportieren.

4. Die thermische Interposer-Komponente von Anspruch 1-3, wobei jener planare Korpus aus Aluminium besteht.

5. Die thermische Interposer-Komponente von Anspruch 1-3, wobei jener planare Korpus aus Graphit besteht.

6. Die thermische Interposer-Komponente von Anspruch 1-5, wobei die modulare Kühlplatten-Anordnung abnehmbar an einen Aufnahmesockel im planaren Korpus gekoppelt ist, wobei jener Aufnahmesockel jenen thermischen Abgabebereich definiert, auf einer Seite jenes planaren Korpus, gegenüber von jener mindestens einen Wärmequelle.

7. Die thermische Interposer-Komponente von Anspruch 6, wobei jene mindestens eine Wärmequelle ein Prozessor ist, der auf jener Computer-Adapterkarte angeordnet ist, und wobei jener thermische Abgabebereich und jene modulare Kühlplatten-Anordnung auf jenem planaren Korpus diametral gegenüberliegend von jenem mindestens einen Prozessor angeordnet sind.

8. Die thermische Interposer-Komponente von Anspruch 6-7, wobei jener thermische Abgabebereich und jene assoziierte modulare Kühlplatten-Anordnung auf jenem planaren Korpus diametral gegenüberliegend von einer Wärmequelle auf jener elektronischen Komponente mit dem größten thermischen Ausstoß angeordnet sind.

9. Die thermische Interposer-Komponente von Anspruch 1-8, wobei jene elektronische Komponente eine Personal-Computer-Adapterkarte ist und wobei jener planare Korpus und jene modulare Kühlplatten-Anordnung, wenn sie operativ zusammengesetzt und an jene Personal-Computer-Adapterkarte gekoppelt sind, in ein ausgewähltes räumliches Volumen passen, das in einem Personal-Computer-Gehäuse einer Personal-Computer-Adapterkarte zugeteilt ist.

10. Die thermische Interposer-Komponente von Anspruch 9, wobei jenes ausgewählte räumliche Volumen durch eine standardmäßige Einzelsteckplatz-Personal-Computer-Adapterkarten-Konfiguration definiert ist.

11. Die thermische Interposer-Komponente von Anspruch 9, wobei jenes ausgewählte räumliche Volumen durch eine standardmäßige Doppelsteckplatz-Personal-Computer-Adapterkarten-Konfiguration definiert ist.

12. Die thermische Interposer-Komponente von Anspruch 1-11, umfassend eine Vielzahl von Wärmerohren, die in dem planaren Korpus versenkt sind, um jene Verteilung und jenen Transfer von thermischer Energie, die durch den planaren Korpus absorbiert wurde, an jene modulare Kühlplatten-Komponente zu ermöglichen.

13. Die thermische Interposer-Komponente von Anspruch 12, wobei jene Vielzahl von Wärmerohren symmetrisch innerhalb des planaren Korpus angeordnet ist.

14. Die thermische Interposer-Komponente von Anspruch 1-13, wobei eine Schicht von Wärmeleitpaste aufgetragen ist, um einen Transfer von thermischer Energie von jenem planaren Korpus an jene modulare Kühlplatten-Komponente zu ermöglichen.

15. Die thermische Interposer-Komponente von Anspruch 1-14, außerdem umfassend ein oder mehrere Wärmeleitpads, die zwischen jener mindestens einen Wärmequelle und jenem planaren Korpus angeordnet sind, um einen Transfer von thermischer Energie an jenen planaren Korpus zu ermöglichen.

16. Die thermische Interposer-Komponente von Anspruch 1-15, wobei jener planare Korpus aus einem unteren planaren Korpus, der zur Platzierung mit einer ersten planaren Oberfläche in thermischer Nachbarschaft zu jener mindestens einer Wärmequelle von jener elektronischen Komponente geeignet ist; und aus einem oberen planaren Korpus mit einer planaren Passfläche, die geeignet ist, gegen eine entsprechende planare Passfläche von jenem unteren planaren Korpus eingepasst zu werden, und außerdem zur Platzierung mit einer zweiten planaren Oberfläche in thermischer Nachbarschaft zu einer zweiten Wärmequelle jener elektronischen Komponente geeignet ist, besteht; und
wobei jener obere planare Korpus und jener untere planare Korpus gemeinsam mindestens einen Durchlass zur Aufnahme jenes Wärmerohrs und jenen thermalen Abgabebereich zur Aufnahme jener modularen Kühlplatten-Anordnung dazwischen definieren.

17. Ein planarer Korpus für eine thermische Interposer-Komponente gemäß Anspruch 1-16, wobei jener planare Korpus aus einem thermisch leitenden Material gemacht ist, für Befestigung an der elektronischen Komponente gestaltet ist, auf einer Seite in thermischem Kontakt mit mindestens einer Wärmequelle auf der elektronischen Komponente ist.

18. Eine modulare Kühlplatten-Anordnung für eine thermische Interposer-Komponente gemäß Anspruch 1-16.

## Revendications

1. Composant formant interposeur thermique (200) pour coupler thermiquement un système de refroidissement par liquide à une carte d'adaptateur d'ordinateur (10 ; 10a, 10b) comportant des sources de chaleur, comprenant :
un corps plan (202 ; 202, 204) en un matériau thermiquement conducteur, configuré pour être attaché à la carte d'adaptateur d'ordinateur, en contact thermique sur une face avec de multiples sources de chaleur sur la carte d'adaptateur d'ordinateur ;
**caractérisé en ce que** le composant formant interposeur thermique comprend en outre une région de décharge thermique (212) formant un espace ou une cavité de réception pour recevoir un ensemble standardisé formant plaque froide modulaire (100) couplé de manière amovible au dit corps plan, ledit ensemble formant plaque froide modulaire étant couplé de manière fonctionnelle à un système de refroidissement par liquide (104) pour transférer l'énergie thermique du corps plan à un liquide de refroidissement circulant dans le système de refroidissement par liquide.

2. Composant formant interposeur thermique selon la revendication 1, dans lequel le corps plan dudit système comprend en outre au moins un caloduc (208) encastré dans le corps plan pour faciliter un transfert et une distribution de l'énergie thermique absorbée par le corps plan à partir desdites sources de chaleur.

3. Composant formant interposeur thermique selon la revendication 2, dans lequel ledit au moins un caloduc est disposé pour transporter l'énergie thermique à travers ledit corps plan vers ledit composant formant plaque froide.

4. Composant formant interposeur thermique selon les revendications 1 à 3, dans lequel ledit corps plan est composé d'aluminium.

5. Composant formant interposeur thermique selon les revendications 1 à 3, dans lequel ledit corps plan est composé de graphite.

6. Composant formant interposeur thermique selon les revendications 1 à 5, dans lequel l'ensemble formant plaque froide modulaire est couplé de manière amovible à une cavité de réception dans le corps plan, ladite cavité de réception définissant ladite région de décharge thermique sur une face dudit corps plan à l'opposé de ladite au moins une source de chaleur.

7. Composant formant interposeur thermique selon la revendication 6, dans lequel ladite au moins une source de chaleur est un processeur disposé sur ladite carte d'adaptateur d'ordinateur, et dans lequel ladite région de décharge thermique et ledit ensemble formant plaque froide modulaire sont disposés diamétralement à l'opposé sur ledit corps plan par rapport au dit au moins un processeur.

8. Composant formant interposeur thermique selon les revendications 6 et 7, dans lequel ladite région de décharge thermique et ledit ensemble formant plaque froide modulaire associé sont disposés sur ledit corps plan diamétralement à l'opposé d'une source de chaleur sur ledit composant électronique ayant la sortie thermique la plus grande.

9. Composant formant interposeur thermique selon les revendications 1 à 8, dans lequel ledit composant électronique est une carte d'adaptateur d'ordinateur personnel, et dans lequel ledit corps plan et ledit ensemble formant plaque froide modulaire, lorsqu'ils sont assemblés et couplés fonctionnellement à ladite carte d'adaptateur d'ordinateur personnel, s'insèrent dans un volume spatial sélectionné attribué à une carte d'adaptateur d'ordinateur personnel dans un châssis d'ordinateur personnel.

10. Composant formant interposeur thermique selon la revendication 9, dans lequel ledit volume spatial sélectionné est défini par une configuration de carte d'adaptateur d'ordinateur personnel à emplacement unique standard.

11. Composant formant interposeur thermique selon la revendication 9, dans lequel ledit volume spatial sélectionné est défini par une configuration de carte d'adaptateur d'ordinateur personnel à deux emplacements standard.

12. Composant formant interposeur thermique selon les revendications 1 à 11, comprenant une pluralité de caloducs intégrés dans le corps plan pour faciliter ladite distribution et ledit transfert de l'énergie thermique absorbée par le corps plan au dit composant formant plaque froide modulaire.

13. Composant formant interposeur thermique selon la revendication 12, dans lequel ladite pluralité de caloducs est disposée symétriquement dans le corps plan.

14. Composant formant interposeur thermique selon les revendications 1 à 13, dans lequel une couche de graisse thermique est disposée pour faciliter un transfert de l'énergie thermique dudit corps plan au dit composant formant plaque froide modulaire.

15. Composant formant interposeur thermique selon les revendications 1 à 14, comprenant en outre un ou plusieurs plots d'espacement thermiques disposés entre ladite au moins une source de chaleur et ledit corps plan pour faciliter un transfert de l'énergie thermique au dit corps plan.

16. Composant formant interposeur thermique selon les revendications 1 à 15, dans lequel ledit corps plan consiste en un corps plan inférieur conçu pour un placement avec une première surface plane adjacente thermiquement à ladite au moins une source de chaleur dudit composant électronique, et un corps plan supérieur comportant une surface d'accouplement plane conçue pour reposer contre une surface d'accouplement plane correspondante dudit corps plan inférieur, et conçu en outre pour un placement avec une deuxième surface plane adjacente thermiquement à une deuxième source de chaleur dudit composant électronique ; et
dans lequel ledit corps plan supérieur et ledit corps plan inférieur définissent en coopération au moins un passage pour recevoir ledit caloduc, et ladite région de décharge thermique pour recevoir ledit ensemble formant plaque froide modulaire entre eux.

17. Corps plan pour un composant formant interposeur thermique selon les revendications 1 à 16, ledit corps plan étant en un matériau thermiquement conducteur, configuré pour être attaché au composant électronique, en contact thermique sur une face avec au moins une source de chaleur sur le composant électronique.

18. Ensemble formant plaque froide modulaire pour un composant formant interposeur thermique selon les revendications 1 à 16.
